# EUROPEAN PATENT APPLICATION

(11) **EP 0 609 504 A1**
(43) Date of publication of application: **10.08.1994**
(21) Application number: 93118651.4
(22) Date of filing: 19.11.1993
(51) Int. Cl.: C23C 14/50, H01L 21/00, B23Q 3/15

(54) **Thin-film electrostatic wafer chuck**

(30) Priority: 25.01.1993 US 979704
(71) Applicant: TEXAS INSTRUMENTS INCORPORATED, Dallas Texas 75265 (US)
(72) Inventor: Robbins, Roger, Allen, TX 75002 (US); Autrey, Dave, Richardson, TX 75081 (US); Pruettiangkura, Pote, Garland, Texas 75040 (US)
(74) Representative: Schwepfinger, Karl-Heinz, Dipl.-Ing.

(57) **Abstract**

The present invention relates to an electrostatic wafer chuck for holding semiconductor wafers of the bipolar type.

The chuck has a base (14) which is covered by first insulating member (16) upon which the electrodes (18,20) are formed. A second insulating layer (24) covers the electrodes so that the wafer (12) may be held in place when suitable potential differences are applied between the electrodes and base member.

The planar nature of the chuck provides good thermal contact for a wafer being processed thereon.

## Description

### FIELD OF THE INVENTION

This invention relates generally to semiconductor wafer processing and more particularly to electrostatic wafer chucks.

### BACKGROUND OF THE INVENTION

Mechanical clamping devices have been used in the past to clamp semiconductor wafers to a chuck while the wafer has been subjected to various processes in vacuum chambers, such as plasma etching. Such method using physical clamping hardware, while being somewhat effective in providing sufficient clamping force to the wafer to provide thermal contact between the wafer and the chuck, also utilize hardware which blocks or otherwise interferes with parameters in the process, such as gas flow or electric field shape. Uniformity of the wafer etch/deposition processes were thus adversely affected. Damaging particles were also introduced into the process chamber.

Electrostatic wafer chucks for semiconductor wafers have been used to overcome the disadvantages of physical clamping devices. They have been of two basic designs, "monopolar" and "bipoloar". The "monopolar" design clamps the wafer by connecting one polarity to an electrode buried in the electrostatic chuck and relies on an induced charge on the wafer to clamp it to the chuck. This method depends on an opposite polarity charge forming on the wafer, which may not be available when needed to clamp the wafer. The "bipolar" design contains two electrodes of opposite polarity buried inside the chuck insulator to create an attractive clamping force regardless of the charge condition of the wafer itself. The "bipolar" design produces a clamping force with the wafer at a "neutral" voltage (ground) midway between the oppositely charged electrodes, which is desirable. Prior "bipolar" designs, however, have used insulating materials which were either not compatible with the processing environment, or did not provide robust insulation, and were destroyed if arcing occurred.
According to the present invention there is provided a wafer chuck and a method of making a wafer chuck as defined in the claims.

### BRIEF DESCRIPTION OF THE DRAWINGS

The preferred embodiment of the present invention is illustrated in the attached drawings, in which:
Fig. 1 is a cross-section of the preferred embodiment of the invention with a semiconductor wafer in place;
Fig. 2 is a plan view of the electrodes of the electrostatic chuck of Fig. 1;
Fig. 3 is a top view on alternative embodiment of the electrostatic chuck; and
Fig. 4 is a graph showing the clamping force generated by the preferred embodiment versus applied voltage.

### DETAILED DESCRIPTION OF THE PREFERRED EMBODIMENT

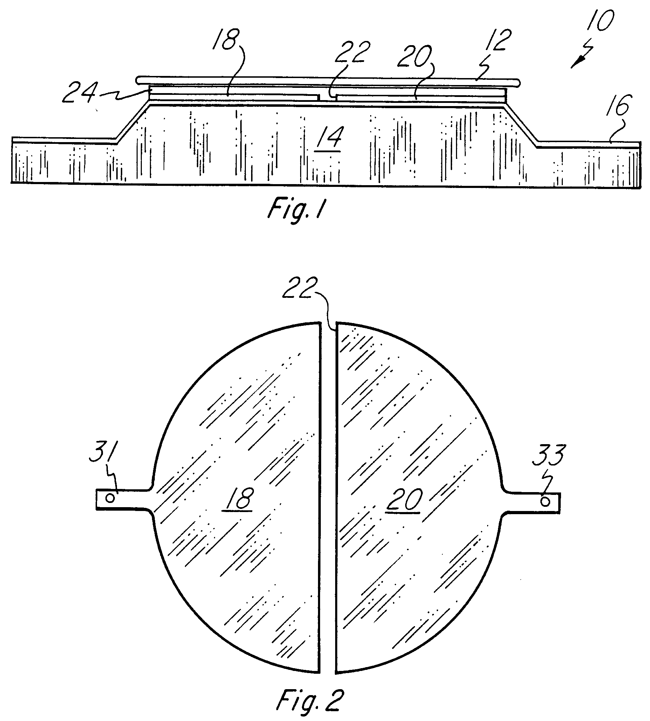

Referring now to Fig. 1, there is shown the electrostatic chuck 10 of the present invention. For simplicity, the chuck 10 is shown with a wafer 12 in place, but the process chamber in which the present invention would be used is omitted. However, as is known to those familiar with semiconductor wafer processing, the chuck 10 would be situated in a process chamber in which various processes such as plasma etching or deposition takes place.

The chuck 10 has a metal base 14, which is preferably aluminum. The base 14 is adapted to be attached to a temperature controlled thermal reservoir (not shown) of some kind known in the art. The thermal reservoir allows for temperature control of the wafer 12 being processed. It may also have ports or gas passages of some type for the introduction of various gases to the chuck 10 or the backside of the wafer 12. There may also be holes through the base 14 for wafer lift pins (not shown) to lift the wafer 12 from the chuck 10 so it can be mechanically removed from the process chamber.

The preferred embodiment includes a base insulating layer 16 formed over the base 14. The base insulator 16 is preferably a hard thick aluminum oxide anodization layer. The layer is polished to a thickness preferably approximately 0.0015 inches. The base insulating layer 16 is provided to electrically isolate electrodes 18 and 20 from the base 14. The electrodes 18 and 20 are made of conductive metal, preferably aluminum. The preferred thickness of the electrodes 18 and 20 is approximately 4,000-5,000 Angstroms. As can be seen from Fig. 2, the electrodes 18 and 20 are separated from one another by gap 22.

A top insulator layer 24 is formed over the top of electrodes 18 and 20. It is preferably a barrier oxidation layer of aluminum oxide, which in the preferred embodiment is approximately 4,000-5,000 Angstroms in thickness. The top insulator layer preferably withstands on the order of 600V.

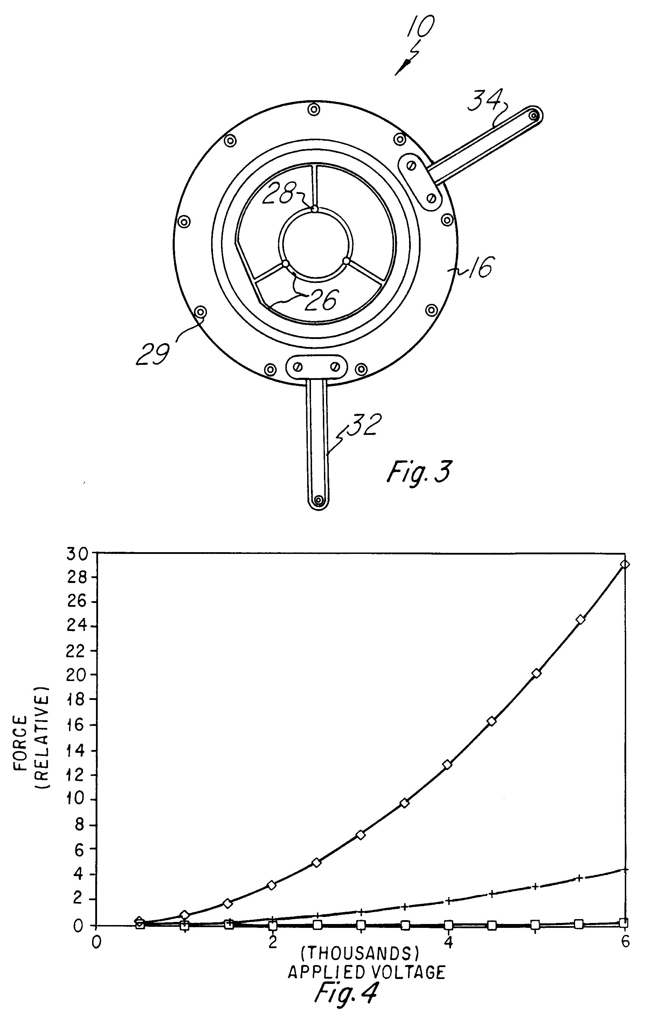

An alternative embodiment is shown in Fig. 3, in which a series of grooves 26 are formed in the clamp 10. The grooves 26 can be connected to wafer lift holes 28, mentioned above. This particular embodiment is designed to allow an insulating ring to cover the outer portion of the chuck in order to shape the plasma and also protect the electrostatic chuck leads and connections. Leads 32 and 34 connect to electrodes 18 and 20. Bolt holes 29 are provided to attached the chuck to its support.

The preferred method of forming the chuck 10 of the present invention is as described below. The base 14 is formed of aluminum. If it is desired to have the gas grooves 26 of the alternative embodiment shown in Fig. 3, they would be formed by conventional milling or other means. Lift holes 28 and any necessary bolt holes would also be bored.

In order to form the base insulating layer 16, the preferred method is to selectively anodize the base 14 in a sulfuric acid bath. The anodization process forms a relatively thick layer of aluminum oxide on the order of 2-3 mils. Portions of the base 14 are masked and not anodized in order to have good electrical contact to an electrode assembly (not shown) to which it will typically be attached. The insulating layer 16 of aluminum oxide is then polished to a smooth surface which is substantially planar. The surface of insulating layer 16 preferably will have no height variation in excess of approximately 1 micro-inch. The overall thickness of insulating layer 16 is preferably approximately 1.5 mils. The gas grooves 26, of course, if formed will be formed in the face of base 14.

One the base insulating layer 16 is formed and polished, a shadow mask (not shown) is made which will outline electrodes 18 and 20, and includes the extensions 31 and 33 shown in Fig. 2. The shadow mask also includes a bar across the periphery along gap 22. The shadow mask is placed over base 14 and pure aluminum is deposited over the exposed portions of base 14 to form the electrodes 18 and 20 and extensions 31 and 33. In the preferred embodiment approximately 8400 Angstroms of aluminum is deposited.

Once the aluminum is deposited, the shadow mask is removed, and a voltage between 600-1000v is applied between the base 14 and the deposited aluminum layer. This voltage so applied will vaporize any metal which might have been deposited in voids in the base insulating layer 16 which extend through or partially through base insulating layer 16. The voltage is also preferably applied in an oxygen atmosphere so oxide will be formed during the voltage conditioning on any exposed metal area, either on base 14 or on the deposited aluminum layer adjacent the voids, which will prevent shorts later on.

The top insulator layer 24 is then formed. Layer 24 is a thin barrier layer formed by anodization of the deposited aluminum layer, preferably in a boric acid bath, at a voltage high enough so that the oxide layer, will withstand approximately 600v.

In this embodiment, electrical contact is made to the electrodes 18 and 20 by physical contact to external leads 32 and 34 at the exposed chuck leads 31 and 33, as shown in Fig. 3, and electrical contact is made to electrodes 18 and 20 as shown.

When the chuck is in use in a process chamber, a wafer is placed on the chuck, and voltage is applied to electrodes 18 and 20, with the voltage of the wafer being at ground potential. In order to control the uniformity of the process, it is typically necessary to control the distribution of heat across the surface of the wafer. Since the surface of the chuck is planar, good thermal contact is maintained across the wafer.

If better thermal control is necessary, the alternative embodiment with gas grooves 26 can be used. With this embodiment, gas, such as helium, is introduced into the grooves 26. As the gas passes through the grooves 26, it will leak out of the grooves 26 and create a uniform gas pressure across the backside of the wafer and provide more uniform temperature, and thus more uniform processes across the face of the wafer.

In order to release the wafer from the chuck, it can be mechanically lifted using lift pins, or the charge on the wafer can be removed by introducing an ionizing gas into the gas grooves 26, and applying a voltage to the underlying electrode, which will dissipate the charge on the wafer, releasing the clamping force.

It is a technical advantage of the invention that the top insulating layer 26, which is in essence a capacitor dielectric, is very thin, since the clamping force exerted on the wafer is inversely proportional to the square of the thickness of the layer.

It is a further technical advantage of the invention that the electrostatic chuck can withstand the harsh environment of a semiconductor wafer process chamber, since it is constructed entirely of aluminum.

It is yet a further technical advantage of the alternative embodiment of the invention that good thermal contact is maintained across the entire surface of the wafer due to the planarity of the chuck surface and the uniformity of the gas pressure on the backside of the wafer. Additionally, since the electrostatic force field attracts the wafer over the entire wafer surface, more uniform contact between the wafer and the chuck is achieved than can be achieved via mechanical clamping. This also leads to better thermal uniformity, and thus better process uniformity.

## Claims

1. A method of making an electrostatic wafer chuck, comprising the steps of:
forming a base;
forming a first insulating layer on the base;
forming a pair of electrodes on the first insulating layer, said pair of electrodes being adjacent one another, each being adapted for connection to a voltage source; and
forming a second insulating layer over the electrodes.

2. The method of claim 1, wherein the step of forming the pair of electrodes further comprises:
masking portions of the first insulating layer; and
depositing a conductive layer over the unmasked portions of the first insulating layer.

3. The method of claim 1, wherein the step of forming the first insulating layer further comprises:
selectively anodizing portions of the base to form an oxide layer thereon.

4. The method of claim 2, wherein the step of forming the second insulating layer further comprises:
anodizing the conductive layer to form an oxide layer thereon; and
polishing said oxide layer.

5. The method of claim 1, further comprising the step of:
applying a voltage between the base and the electrodes.

6. The method of claim 1, further comprising the step of:
forming a groove in a face of the base.

7. An electrostatic wafer chuck, comprising:
a base;
a first insulating layer formed on the base;
a pair of electrodes formed on the first insulating layer, said pair of electrodes being adjacent one another, each of said electrodes adapted for connection to a voltage source; and
a second insulating layer formed over the electrodes.

8. The wafer chuck of claim 7, wherein grooves are formed in the face.
